# EUROPEAN PATENT APPLICATION

(11) **EP 4 803 972 A1**
(43) Date of publication of application: **09.09.2026**
(21) Application number: 24907806.4
(22) Date of filing: 18.11.2024
(51) Int. Cl.: G06F 1/16, H05K 5/00, A45C 11/00

(54) **COVER AND ELECTRONIC DEVICE ON WHICH COVER IS MOUNTED**

(30) Priority: 18.12.2023 KR 20230184709; 18.01.2024 KR 20240007935
(71) Applicant: Samsung Electronics Co., Ltd., Suwon-si, Gyeonggi-do 16677 (KR)
(72) Inventor: KIM, Yongil, Suwon-si, Gyeonggi-do 16677 (KR); KANG, Haewoong, Suwon-si, Gyeonggi-do 16677 (KR); KO, Junho, Suwon-si, Gyeonggi-do 16677 (KR); AN, Youngjun, Suwon-si, Gyeonggi-do 16677 (KR); RHEE, Minsu, Suwon-si, Gyeonggi-do 16677 (KR); LIM, Gun, Suwon-si, Gyeonggi-do 16677 (KR)
(74) Representative: Gulde & Partner
(86) International application number: PCT/KR2024/018149
(87) International publication number: WO 2025/135521

(57) **Abstract**

According to an embodiment of the disclosure, an electronic device including a cover may comprise an input device that receives sound and a housing comprising a first opening through which sound received by the input device passes, wherein the cover comprises a first cover hole formed at a position overlapping with the first opening, a placement space where an external device can be placed, and formed between a first side surface of the housing where the first opening is formed and a first cover side surface of the cover where the first cover hole is formed, and a partition wall facing the first side surface and covering a portion of the placement space, wherein a portion of the placement space not covered by the partition wall extends from the first opening to the first cover hole.

## Description

### [Technical Field]

The disclosure relates to a cover and an electronic device on which the cover is mounted.

### [Background Art]

A cover (e.g., a protective cover) may be mounted on an electronic device (e.g., a portable electronic device). The cover may be disposed on the electronic device so as to surround a perimeter of the electronic device. The cover may serve to protect the electronic device from an external impact.

The cover may include a space into which an external device (e.g., a digital pen) is inserted. The cover may be mounted on the electronic device, and the external device may be inserted into and disposed in the cover.

The above-described information may be provided as related art for the purpose of assisting in understanding the disclosure. None of the foregoing might be asserted as prior art relevant to the disclosure or used for determination on prior art.

### [Disclosure of Invention]

### [Solution to Problem]

An electronic device according to an embodiment of the disclosure may include a cover mounted thereon.

In an embodiment, the electronic device may include an input device configured to receive a sound and a housing including a first opening through which the sound delivered to the input device passes.

In an embodiment, the cover may include a first cover hole, a placement space, and a partition wall.

In an embodiment, the first cover hole may be formed at a position overlapping the first opening.

In an embodiment, the placement space may be formed between a first side surface of the housing in which the first opening is formed and a first cover side surface of the cover in which the first cover hole is formed, and an external device may be placed in the placement space.

In an embodiment, the partition wall may face the first side surface and may cover a portion of the placement space.

In an embodiment, a region of the placement space that is not covered by the partition wall may extend from the first opening to the first cover hole.

A cover mountable on an electronic device according to an embodiment of the disclosure may include a first cover hole, a placement space, and a partition wall.

In an embodiment, the first cover hole may be formed at a position capable of overlapping a first opening of the electronic device through which a sound delivered to the electronic device passes.

In an embodiment, an external device may be placed in the placement space.

In an embodiment, the partition wall may face a first side surface of the electronic device and may cover a portion of the placement space.

In an embodiment, when the cover is mounted on the electronic device, a region of the placement space that is not covered by the partition wall may extend from the first opening to the first cover hole.

### [Brief Description of Drawings]

FIG. 1 is a block diagram of an electronic device in a network environment, according to an embodiment of the disclosure.
FIGS. 2A and 2B are perspective views of an electronic device according to an embodiment of the disclosure.
FIGS. 3A and 3B are views illustrating an electronic device according to an embodiment of the disclosure.
FIGS. 4A, 4B, and 4C are views illustrating a cover according to an embodiment of the disclosure and an electronic device on which the cover is mounted.
FIG. 5 is a view illustrating an external device according to an embodiment of the disclosure.
FIGS. 6A and 6B are views illustrating an electronic device, a cover, and an external device according to an embodiment of the disclosure.
FIG. 7 is a view illustrating a groove formed in a cover according to an embodiment of the disclosure.
FIGS. 8A and 8B are views illustrating a placement space and a groove according to an embodiment of the disclosure.
FIGS. 9A and 9B are views illustrating a first groove and a second groove according to an embodiment of the disclosure.
FIG. 10 is a view illustrating a second cover hole according to an embodiment of the disclosure.
FIG. 11 is a view illustrating a second cover hole according to an embodiment of the disclosure.
FIGS. 12A, 12B, and 12C are views illustrating passages according to an embodiment of the disclosure.
FIGS. 13A and 13B are views illustrating an external electronic device according to an embodiment of the disclosure.
FIG. 14 is a view illustrating a protrusion according to an embodiment of the disclosure.
FIG. 15 is a first graph illustrating a sound pressure level of a sound measured at an input device according to an embodiment of the disclosure.
FIG. 16 is a second graph illustrating a sound pressure level of a sound generated by an acoustic output device according to an embodiment of the disclosure.

### [Mode for the Invention]

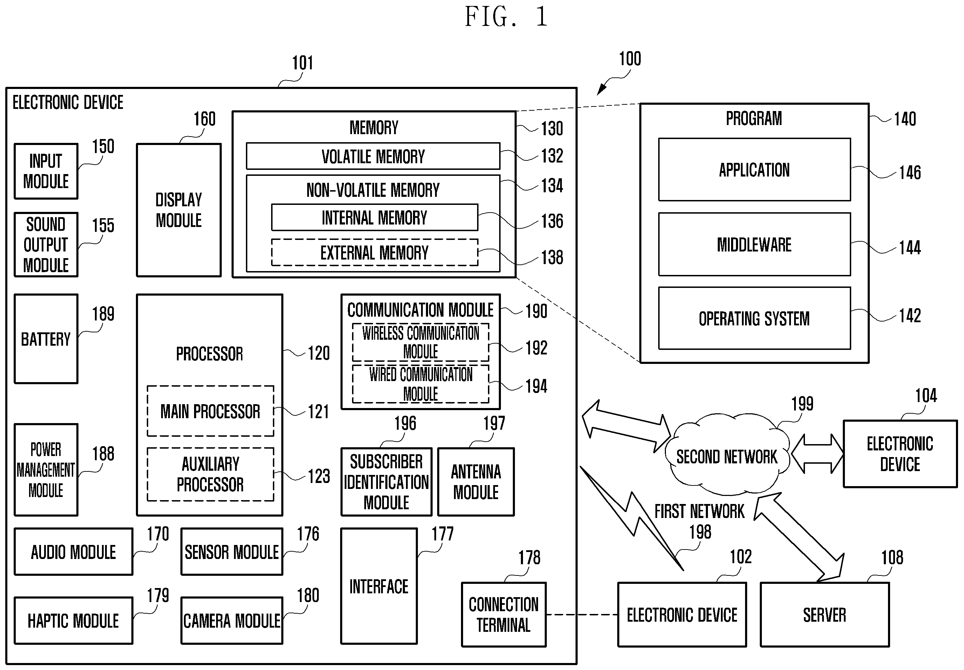

Fig. 1 is a block diagram illustrating an electronic device 101 in a network environment 100 according to various embodiments. Referring to Fig. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thererto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

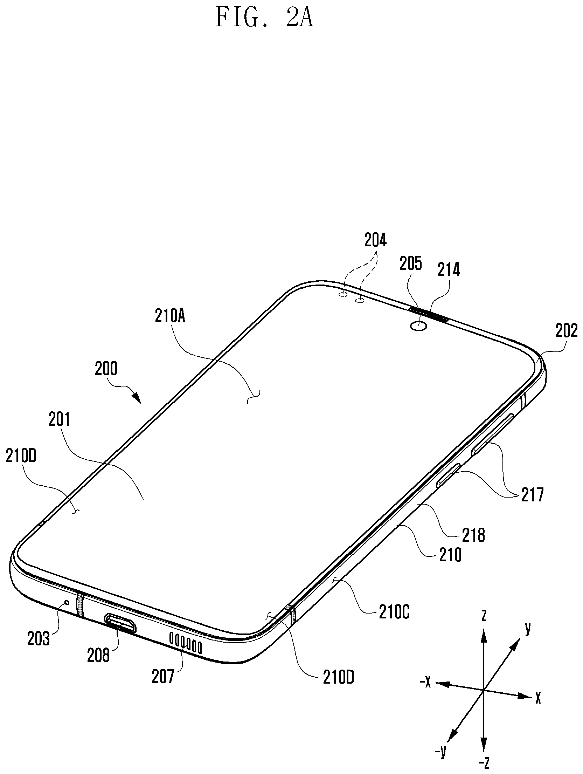

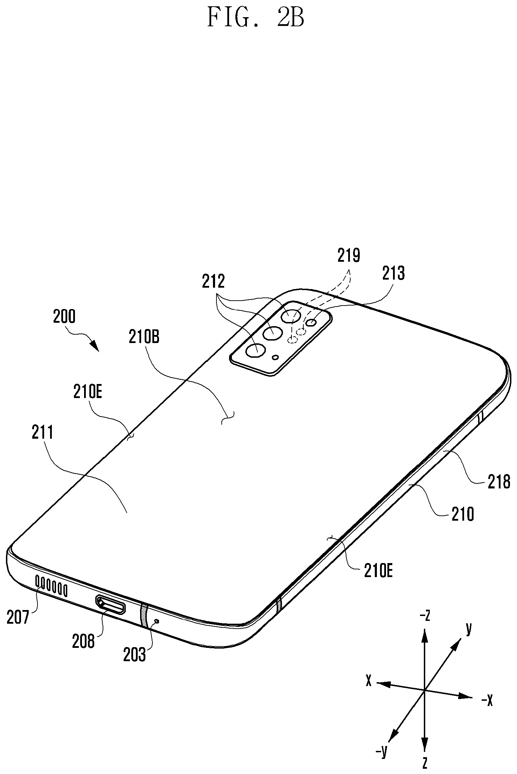

FIG. 2A is a front perspective view of an electronic device 200 according to an embodiment of the disclosure. FIG 2B is a rear perspective view of the electronic device 200 of FIG. 2A, according to an embodiment of the disclosure.

The electronic device 200 of FIGS. 2A and 2B may be at least partially similar to the electronic device 101 of FIG. 1 or may include at least some of the components of the electronic device 101 of FIG. 1.

Referring to FIGS. 2A and 2B, the electronic device 200 according to an embodiment may include a housing 210 including a first surface (or front surface) 210A, a second surface (or rear surface) 210B, and a side surface 210C surrounding a space between the first surface 210A and the second surface 210B. In an embodiment (not illustrated), the housing 210 may also refer to a structure that forms part of the first surface 210A, the second surface 210B, and the side surface 210C. According to an embodiment, the first surface 210A may be formed by a front surface plate 202 at least a portion of which is substantially transparent (e.g., a glass plate including various coating layers, or a polymer plate). The second surface 210B may be formed by a rear surface plate 211 that is substantially opaque. The rear surface plate 211 may be formed of, for example, coated or colored glass, ceramic, polymer, metal (e.g., aluminum, stainless steel (STS), or magnesium), or a combination of at least two of the foregoing materials. The side surface 210C may be formed by a side surface bezel structure (or a "side surface structure") 218 coupled to the front surface plate 202 and the rear surface plate 211 and including metal and/or polymer. In some embodiments, the rear surface plate 211 and the side bezel surface structure 218 may be integrally formed and may include the same material (e.g., a metal material such as aluminum).

In the illustrated embodiment, the front surface plate 202 may include, at opposite long edges thereof, first regions 210D bent from the first surface 210A toward the rear surface plate and extending seamlessly. In the illustrated embodiment (see FIG. 2B), the rear surface plate 211 may include, at opposite long edges thereof, second regions 210E bent from the second surface 210B toward the front surface plate and extending seamlessly. In some embodiments, the front surface plate 202 or the rear surface plate 211 may include only one of the first regions 210D or one of the second regions 210E. In some embodiments, the front surface plate 202 may not include the first region and the second region, and may include only a flat surface disposed parallel to the second surface 210B. In the above-described embodiments, when viewed from a side of the electronic device, the side surface bezel structure 218 may have a first thickness (or width) at the side of the side surface that does not include the first region 210D or the second region 210E, and may have a second thickness smaller than the first thickness at the side of the side surface that includes the first region or the second region.

According to an embodiment, the electronic device 200 may include at least one of a display 201, an input device 203, acoustic output devices 207 and 214, sensor modules 204 and 219, camera modules 205, 212, and 213, key input devices 217, an indicator (not illustrated), and a connector hole 208. In some embodiments, at least one of the components (e.g., the key input devices 217 or the indicator) of the electronic device 200 may be omitted or another component may be additionally included.

The display 201 may be exposed through, for example, a substantial portion of the front surface plate 202. In an embodiment, at least a portion of the display 201 may be exposed through the front surface plate 202 forming the first surface 210A and the first regions 210D of the side surface 210C. The display 201 may be coupled to or disposed adjacent to touch detection circuitry, a pressure sensor capable of measuring an intensity (pressure) of touch, and/or a digitizer configured to detect a stylus pen of a magnetic-field type. In some embodiments, at least one of the sensor modules 204 and 219 and/or at least one of the key input devices 217 may be disposed in the first regions 210D and/or the second regions 210E.

The input device 203 may include a microphone. In an embodiment, the input device 203 may include a plurality of microphones disposed to detect a direction of a sound. The acoustic output devices 207 and 214 may include speakers. The speakers may include an external speaker 207 and a receiver 214 for a call. In some embodiments, the microphone, the speakers, and the connector hole 208 may be disposed in the space of the electronic device 200 and may be exposed to an external environment through at least one hole formed in the housing 210. In some embodiments, the hole formed in the housing 210 may be commonly used for the microphones and the speakers. In some embodiments, the acoustic output devices 207 and 214 may include a speaker (e.g., a piezo speaker) operated without a hole formed in the housing 210.

The sensor modules 204 and 219 may generate an electrical signal or data value corresponding to an operating state inside the electronic device 200 or an environmental state outside the electronic device 200. The sensor modules 204 and 219 may include, for example, a first sensor module 204 (e.g., a proximity sensor) and/or a second sensor module (not illustrated) (e.g., a fingerprint sensor) disposed on the first surface 210A of the housing 210, and/or a third sensor module 219 (e.g., an HRM sensor) disposed on the second surface 210B of the housing 210. The fingerprint sensor may be disposed on the first surface 210A of the housing 210. The fingerprint sensor (e.g., an ultrasonic fingerprint sensor or an optical fingerprint sensor) may be disposed under the display 201 on the first surface 210A. The electronic device 200 may further include a sensor module (not illustrated), for example, at least one of a gesture sensor, a gyro sensor, a barometric sensor, a magnetic sensor, an acceleration sensor, a grip sensor, a color sensor, an infrared (IR) sensor, a biometric sensor, a temperature sensor, a humidity sensor, or an illuminance sensor 204.

According to an embodiment, the camera modules 205, 212, and 213 may include a first camera device 205 disposed on the first surface 210A of the electronic device 200, a second camera device 212 disposed on the second surface 210B, and/or a flash 213. The camera modules 205 and 212 may include one or more lenses, an image sensor, and/or an image signal processor. The flash 213 may include, for example, a light-emitting diode or a xenon lamp. In some embodiments, two or more lenses (a wide-angle lens and a telephoto lens) and image sensors may be disposed on one surface of the electronic device 200.

The key input devices 217 may be disposed on the side surface 210C of the housing 210. In an embodiment, the electronic device 200 may not include some or all of the above-mentioned key input devices 217, and the key input devices 217 not included may be implemented in another form, such as soft keys on the display 201. As an embodiment, the key input devices 217 may be implemented using pressure sensors included in the display 201.

The indicator may be disposed on, for example, the first surface 210A of the housing 210. The indicator may provide, for example, state information of the electronic device 200 in the form of light. In an embodiment, the light-emitting element may provide, for example, a light source operated in conjunction with the operation of the camera module 205. The indicator may include, for example, an LED, an IR LED, and a xenon lamp.

The connector hole 208 may include a first connector hole 208 capable of accommodating a connector (e.g., a USB connector or an interface connector port module) configured to transmit and/or receive power and/or data to and/or from an external electronic device, and/or a second connector hole (or an earphone jack) capable of accommodating a connector configured to transmit and/or receive an audio signal to and/or from an external electronic device. At least one of the camera modules 205 and 212, at least one of the sensor modules 204 and 219, or the indicator may be disposed to be exposed through the display 201. For example, the camera module 205, the sensor module 204, or the indicator may be disposed in an inner space of the electronic device 200 so as to contact an external environment through an opening or a transmission region of the display 201 perforated to the front surface plate 202. According to an embodiment, a region in which the display 201 and the camera module 205 face each other may be formed as a transmission region having a predetermined transmittance, as a portion of a region for displaying content. According to an embodiment, the transmission region may be formed to have a transmittance ranging from about 5% to about 20%. The transmission region may include a region overlapping an effective region (e.g., a field-of-view region) of the camera module 205 through which light for forming an image on the image sensor passes. For example, the transmission region of the display 201 may include a region having a lower pixel density than a surrounding region. For example, the transmission region may replace the opening. For example, the camera module 205 may include an under-display camera (UDC). As an embodiment, the at least one sensor module 204 may be disposed to perform functions thereof without being visually exposed through the front surface plate 202 from the inner space of the electronic device. For example, in this case, a perforated opening may be unnecessary in a region of the display 201 facing the sensor module.

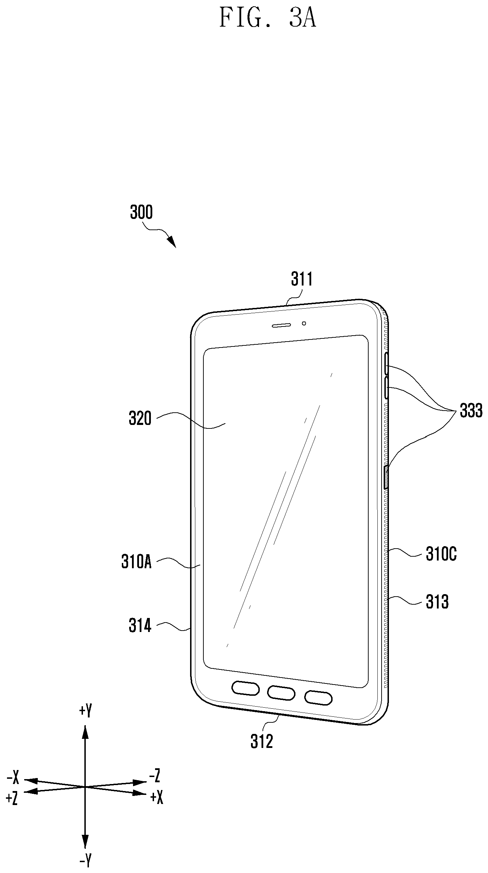

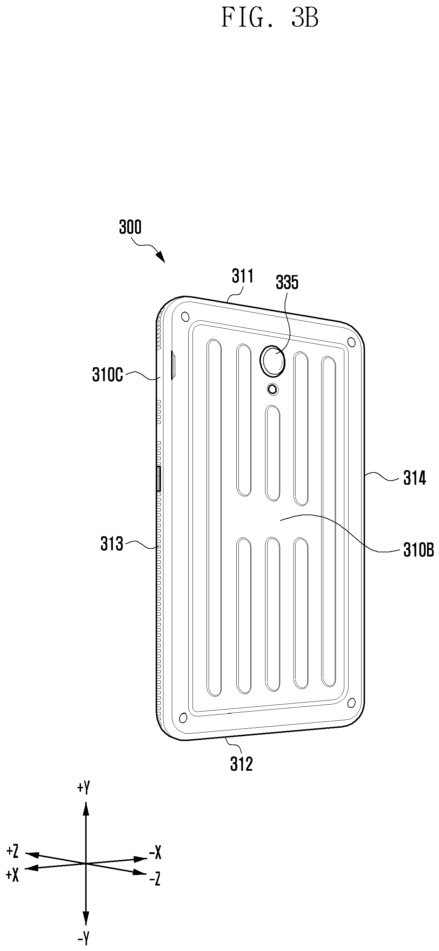

FIGS. 3A and 3B are views illustrating an electronic device 300 according to an embodiment of the disclosure.

FIG. 3A is a perspective view illustrating a front surface of the electronic device 300 according to an embodiment. FIG. 3B is a perspective view illustrating a rear surface of the electronic device 300 according to an embodiment.

The electronic device 300 illustrated in FIGS. 3A and 3B may refer to the electronic device 101 illustrated in FIG. 1, or may include at least some of the components of the electronic device 101 illustrated in FIG. 1.

The electronic device 300 illustrated in FIGS. 3A and 3B may refer to the electronic device 200 illustrated in FIGS. 2A and 2B, or may include at least some of the components of the electronic device 200 illustrated in FIGS. 2A and 2B.

In describing the electronic device 300 according to an embodiment of the disclosure, the width direction of the electronic device 300 may refer to an X-axis direction, and the length direction of the electronic device 300 may refer to a Y-axis direction. The height direction of the electronic device 300 may refer to a Z-axis direction.

Referring to FIGS. 3A and 3B, the electronic device 300 according to an embodiment may include a housing 310, a display 320, key input devices 333, and/or a camera module 335.

In an embodiment, the housing 310 may be substantially identical to the housing 210 of FIGS. 2A and 2B.

In an embodiment, the housing 310 may include a first surface 310A, a second surface 310B, and a side surface 310C surrounding a space between the first surface 310A and the second surface 310B.

In an embodiment, the housing 310 may also refer to a structure forming part of the first surface 310A, the second surface 310B, and the side surface 310C.

In an embodiment, the side surface 310C of the housing 310 may include a first side surface 311, a second side surface 312, a third side surface 313, and/or a fourth side surface 314. The second side surface 312 may be a surface facing opposite to the first side surface 311. The fourth side surface 314 may be a surface facing opposite to the third side surface 313. The first side surface 311, the second side surface 312, the third side surface 313, and the fourth side surface 314 may be formed separately or integrally.

In an embodiment, the housing 310 may form an exterior of the electronic device 300. In an embodiment, at least some of the components of the electronic device 300 may be disposed in the housing 310.

In an embodiment, the display 320 may be disposed in the housing 310. For example, the display 320 may be disposed on the first surface 310A of the housing 310. Alternatively, the display 320 may be disposed to be at least partially exposed to the outside through the first surface 310A of the housing 310.

In an embodiment, the display 320 may visually provide information to the outside of the electronic device 300 (e.g., to a user). According to an embodiment, the display 320 may include a touch sensor configured to detect a touch or a pressure sensor configured to measure an intensity of a force generated by the touch.

In an embodiment, the electronic device 300 may include one or more key input devices 333. The key input devices 333 may be disposed on the side surface 310C of the housing 310.

In an embodiment, the electronic device 300 may not include some or all of the plurality of key input devices 333. For example, in an embodiment, the key input device 333 may be implemented using a pressure sensor included in the display 320.

In an embodiment, the camera module 335 may capture a still image and a video image. According to an embodiment, the camera module 335 may include one or more lenses, image sensors, image signal processors, or flashes. In an embodiment, the camera module 335 may be exposed to the outside of the electronic device 300 on the second surface 310B of the housing 310.

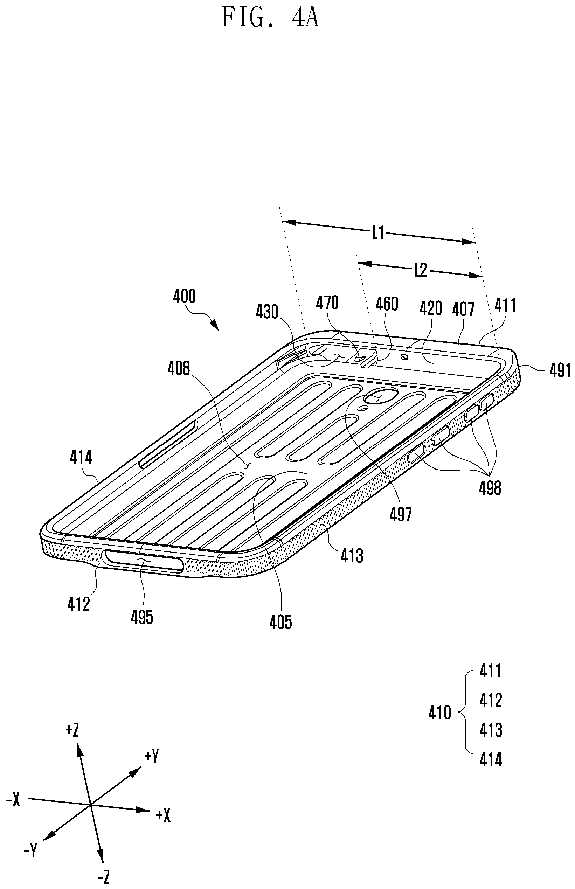

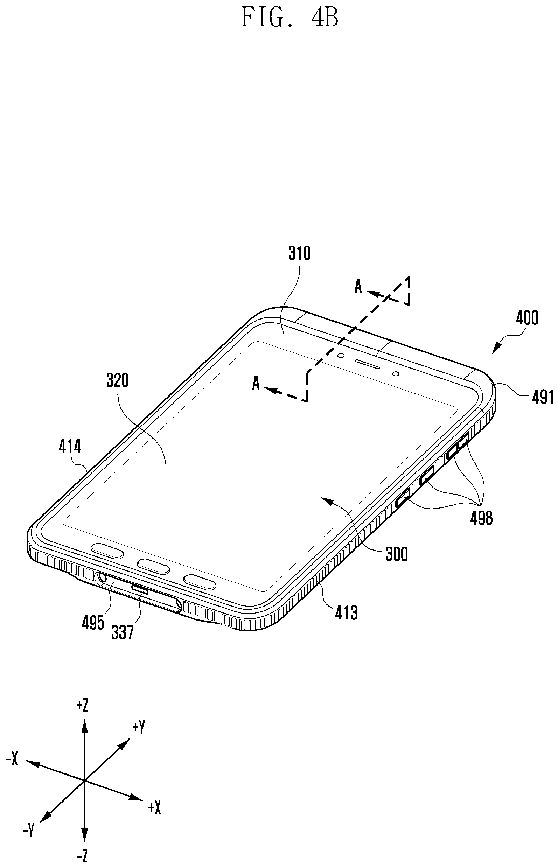

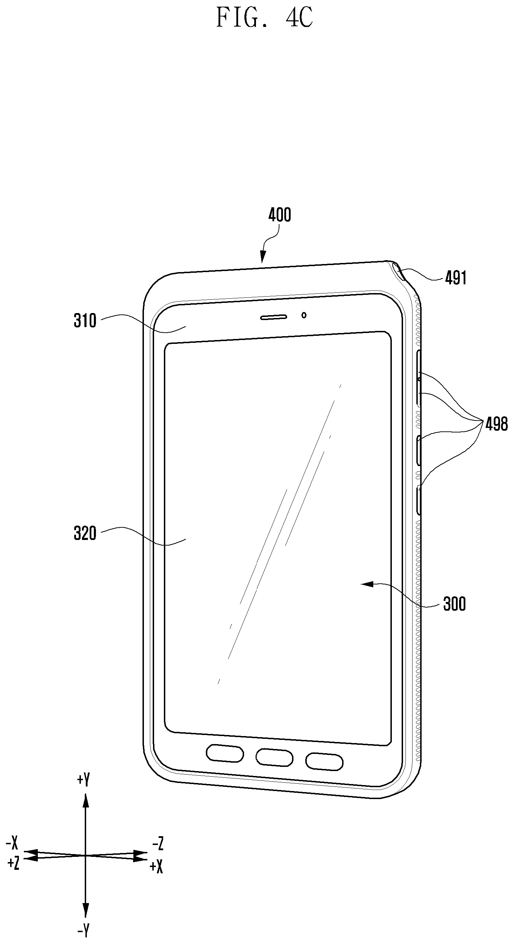

FIGS. 4A, 4B, and 4C are views illustrating a cover 400 according to an embodiment of the disclosure and an electronic device 300 on which the cover 400 is mounted.

FIG. 4A is a view illustrating the cover 400 according to an embodiment. FIG. 4B is a view illustrating the electronic device 300 on which the cover 400 according to an embodiment is mounted. FIG. 4C is a view illustrating an external device hole 491 of the electronic device 300 on which the cover 400 is mounted.

In describing the cover 400 according to an embodiment of the disclosure, the width direction of the cover 400 may refer to an X-axis direction, and the length direction of the cover 400 may refer to a Y-axis direction. The height direction of the cover 400 may refer to a Z-axis direction.

Referring to FIG. 4A, the cover 400 according to an embodiment may include a support surface 405, a cover top surface 407, a side surface 410, a partition wall 420, a placement space 430, a groove 460, a protrusion 470, an external device hole 491, a port hole 495, a camera hole 497, and input portions 498.

In an embodiment, the support surface 405 may refer to a surface of the cover 400 that is substantially perpendicular to the height direction of the cover 400 (e.g., the Z-axis direction).

In an embodiment, the support surface 405 and the cover side surface 410 may be substantially perpendicular to each other. In an embodiment, the support surface 405 and the cover side surface 410 may be integrally formed.

In an embodiment, the cover side surface 410 may include a first cover side surface 411, a second cover side surface 412, a third cover side surface 413, and/or a fourth cover side surface 414.

In an embodiment, the cover 400 may include the partition wall 420. In an embodiment, the partition wall 420 may be formed to face the first cover side surface 411.

In an embodiment, the support surface 405, the cover side surface 410, and the partition wall 420 may form a seating space 408. The seating space 408 may be a space surrounded by the support surface 405, the cover side surface 410, and the partition wall 420.

In an embodiment, an electronic device 300 (see FIG. 3A) may be disposed in the seating space 408 of the cover 400. When the electronic device 300 (see FIG. 3A) is disposed in the seating space 408 of the cover 400, at least a portion of the support surface 405 may come into contact with the second surface 310B (see FIG. 3B) of the housing 310 (see FIG. 3B) of the electronic device 300 (see FIG. 3A).

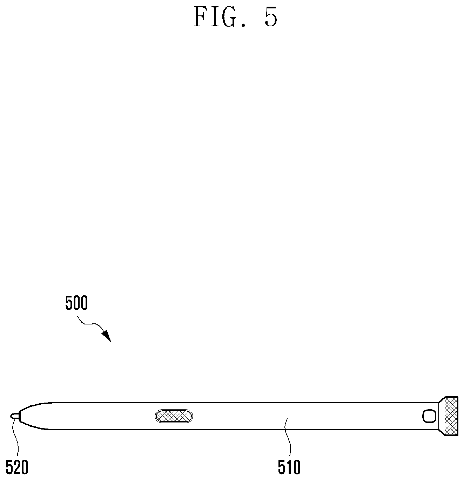

In an embodiment, the cover 400 may include a placement space 430 in which an external device 500 (see FIG. 5) may be placed. The external device 500 (see FIG. 5) may be inserted through the external device hole 491 and placed in the placement space 430.

In an embodiment, the partition wall 420 may serve to support the external device 500 (see FIG. 5) inserted into the cover 400. The partition wall 420 may support the external device 500 (see FIG. 5) inserted into the cover 400 so that the external device 500 maintains a predetermined position.

In an embodiment, the placement space 430 may be surrounded by the first cover side surface 411, the cover top surface 407, and the partition wall 420.

In an embodiment, the partition wall 420 may be formed with at least a portion thereof removed. For example, a portion of the partition wall 420 facing the first cover side surface 411 may be removed.

In an embodiment, the partition wall 420 may be formed to cover only a portion of the placement space 430. For example, referring to FIG. 4, the length by which the placement space 430 extends in the width direction of the cover 400 (e.g., the X-axis direction) may be a first length L1. The length by which the partition wall 420 extends in the width direction of the cover 400 (e.g., the X-axis direction) may be a second length L2 smaller than the first length L1. Only a portion of the placement space 430 may be covered by the partition wall 420, and a remaining portion may not be covered by the partition wall 420.

In an embodiment, a region of the placement space 430 that is not covered by the partition wall 420 may be exposed toward the seating space 408.

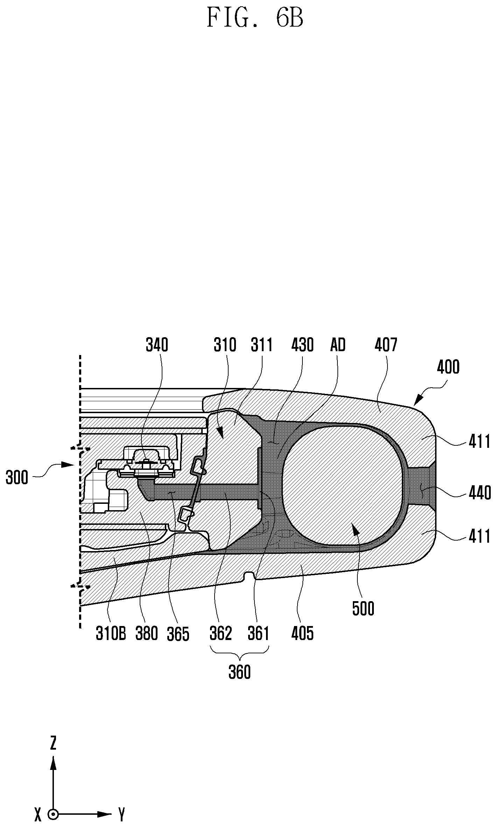

In an embodiment, a groove 460 may be formed on some of the surfaces surrounding the placement space 430. The groove 460 may be formed in a shape in which the surfaces surrounding the placement space 430 are partially recessed. The groove 460 may serve to expand an acoustic duct AD (see FIG. 6B).

In an embodiment, a protrusion 470 may be formed in the placement space 430. The protrusion 470 may serve to fix the position of the external device 500 (see FIG. 5) placed in the cover 400.

In an embodiment, the protrusion 470 may be formed in the region of the placement space 430 that is not covered by the partition wall 420.

Referring to FIG. 4B, the cover 400 may be mounted on the electronic device 300. The cover 400 may be mounted on the electronic device 300 so as to surround the second surface 310B (see FIG. 3B) and the side surface 310C (see FIG. 3B) of the housing 310 of the electronic device 300.

In an embodiment, when the cover 400 is mounted on the electronic device 300, the first side surface 311 (see FIG. 3B) of the housing 310 may be disposed to face the first cover side surface 411, and the second side surface 312 (see FIG. 3B) of the housing 310 may be disposed to face the second cover side surface 412.

In an embodiment, when the cover 400 is mounted on the electronic device 300, the second surface 310B (see FIG. 3B) of the housing 310 may face at least a portion of the support surface 405 of the cover 400.

Referring to FIG. 4B, the electronic device 300 according to an embodiment may include a connector hole 337. The connector hole 337 may accommodate a connector (e.g., a USB connector or an interface connector port (IF) module) configured to transmit and/or receive power and/or data to and/or from an external electronic device.

In an embodiment, a port hole 495 may be formed in the cover side surface 410. For example, the port hole 495 may be formed in the second cover side surface 412. Referring to FIG. 4B, the port hole 495 may be formed at a position corresponding to the connector hole 337 of the electronic device 300.

In an embodiment, when the cover 400 is mounted on the electronic device 300, the camera hole 497 may be positioned to correspond to the camera module 335 (see FIG. 3B) of the electronic device 300. The camera module 335 (see FIG. 3B) of the electronic device 300 may be exposed to the outside of the cover 400 through the camera hole 497.

In an embodiment, when the cover 400 is mounted on the electronic device 300, the input portions 498 may be positioned to correspond to the key input devices 333 (see FIG. 3A) of the electronic device 300. Pressure applied to the respective input portions 498 may be delivered to the key input devices 333 (see FIG. 3A).

Referring to FIG. 4C, the cover 400 may be mounted on the electronic device 300. The cover 400 may be disposed on the electronic device 300 so as to surround a perimeter of the electronic device 300. The display 320 may be exposed to the outside of the electronic device 300 on which the cover 400 is mounted.

Referring to FIG. 4C, in an embodiment, the external device hole 491 may be formed in a portion of the cover 400. The external device hole 491 may include an opening shape so that the external device 500 (see FIG. 5) may be inserted into the cover 400.

In an embodiment, the external device hole 491 may be oriented in the width direction of the cover 400 (e.g., the X-axis direction). In an embodiment, the external device hole 491 may extend in a portion of the cover 400 along the width direction of the cover 400 (e.g., the X-axis direction).

In an embodiment, the external device 500 (see FIG. 5) may be inserted into the cover 400 through the external device hole 491. For example, the external device 500 (see FIG. 5) may be inserted through the external device hole 491 in the width direction of the cover 400 (e.g., the X-axis direction).

In an embodiment, the external device 500 (see FIG. 5) may be detachably disposed in the cover 400 through the external device hole 491.

FIG. 5 is a view illustrating an external device 500 according to an embodiment of the disclosure.

The external device 500 according to an embodiment of the disclosure may include a body 510 and/or a pen tip 520.

In an embodiment, the external device 500 may be a digital pen. For example, the external device 500 may be a digital pen serving to transmit an input by a user to the electronic device 300 (see FIG. 3A).

In an embodiment, the body 510 may extend in one direction. The body 510 may form an exterior of the external device 500 and may serve as a housing surrounding components of the external device 500.

In an embodiment, the pen tip 520 may protrude from the body 510. The pen tip 520 may include a dielectric tip. The pen tip 520 may come into contact with the display 320 (see FIG. 3A) of the electronic device 300 (see FIG. 3A).

In an embodiment, the external device 500 may be placed in the placement space 430 (see FIG. 4A) of the cover 400 (see FIG. 4A). For example, the external device 500 may be detachably placed in the cover 400 (see FIG. 4A) through the external device hole 491 (see FIG. 4A).

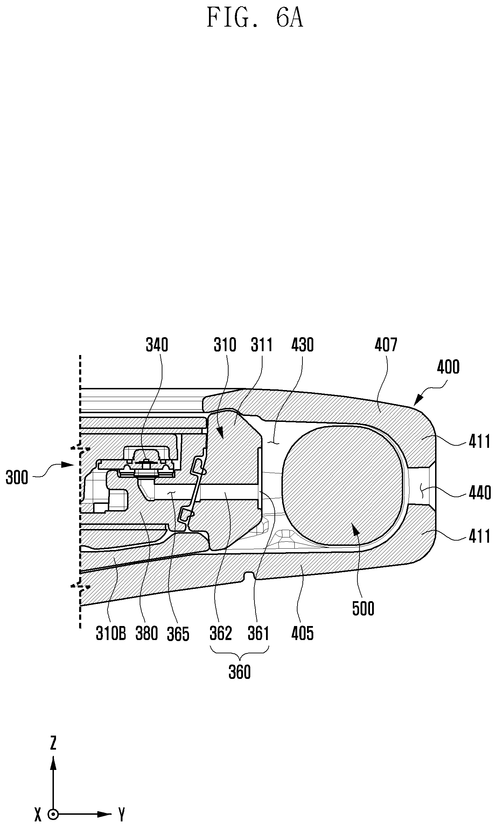

FIGS. 6A and 6B are views illustrating an electronic device 300, a cover 400, and an external device 500 according to an embodiment of the disclosure.

FIG. 6A is a view illustrating the electronic device 300, the cover 400, and the external device 500 according to an embodiment. FIG. 6A may be a view illustrating a state in which the cover 400 is mounted on the electronic device 300 and the external device 500 is placed in the cover 400.

FIG. 6B is a view illustrating an acoustic duct AD formed in a placement space 430 according to an embodiment.

FIGS. 6A and 6B may be views illustrating the electronic device 300, the cover 400, and the external device 500 taken along line A-A of FIG. 4B.

Referring to FIG. 6A, the electronic device 300 may include an input device 340.

In an embodiment, the input device 340 may include a microphone. The input device 340 may serve to receive a sound generated outside the electronic device 300 and the cover 400.

In an embodiment, a first opening 360 may be formed in the first side surface 311 of the housing 310.

In an embodiment, the first opening 360 may include a first portion 361 and/or a second portion 362. The first portion 361 may be a portion formed on a surface of the first side surface 311. The second portion 362 may have a width smaller than that of the first portion 361 and may be a portion extending toward the input device 340.

In an embodiment, the electronic device 300 may include a first duct 365 extending toward the input device 340. The first duct 365 may extend toward the input device 340 through a mechanical structure 380 of the electronic device 300.

In an embodiment, a sound generated outside the electronic device 300 may be delivered to the input device 340 along the first opening 360 and the first duct 365.

In an embodiment, when the cover 400 is mounted on the electronic device 300, the second surface 310B of the housing 310 may be disposed to face at least a portion of the support surface 405.

In an embodiment, the cover 400 may include a first cover hole 440. The first cover hole 440 may be formed in the first cover side surface 411.

In an embodiment, when the cover 400 is mounted on the electronic device 300, the first opening 360 and the first cover hole 440 may be positioned to be aligned with each other. For example, when viewed in the length direction of the cover 400 (e.g., the Y-axis direction), the first opening 360 and the first cover hole 440 may be positioned to overlap each other.

In an embodiment, the external device 500 may be placed in the placement space 430 of the cover 400.

Referring to FIGS. 6A and 6B, an acoustic duct AD may be formed in the placement space 430. When the external device 500 is placed in the cover 400, the acoustic duct AD may be formed around the external device 500. For example, the acoustic duct AD may be formed in the placement space 430 located between the external device 500 and the support surface 405 and between the external device 500 and the cover top surface 407. The acoustic duct AD may be formed through the first cover hole 440, around the external device 500, and through the first opening 360 and the first duct 365. A sound generated outside the electronic device 300 and the cover 400 may move through the acoustic duct AD and may be delivered to the input device 340.

In an embodiment, the partition wall 420 (see FIG. 4A) of the cover 400 may not overlap the first opening 360. For example, the partition wall 420 (see FIG. 4A) of the cover 400 may not overlap the first portion 361 of the first opening 360. Since the partition wall 420 (see FIG. 4A) of the cover 400 does not overlap the first opening 360, the acoustic duct AD connected to the first opening 360 may be relatively expanded.

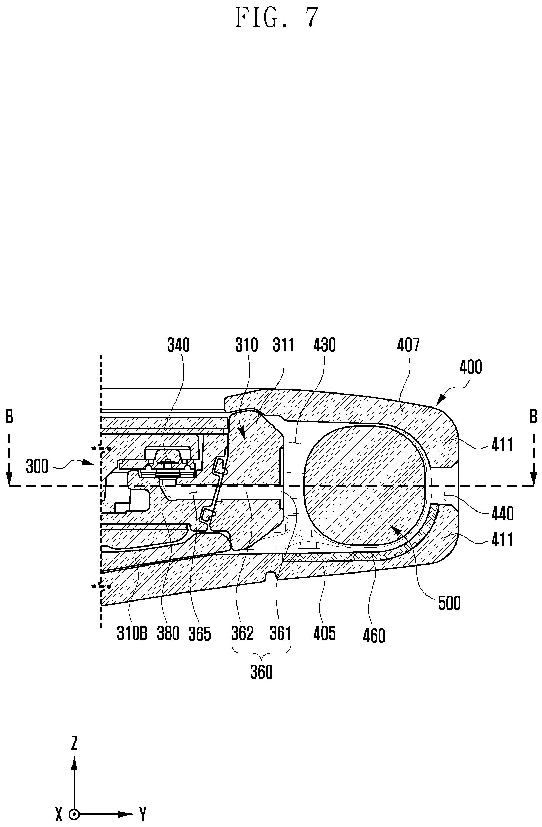

FIG. 7 is a view illustrating a groove 460 formed in the cover 400 according to an embodiment of the disclosure.

FIG. 7 may be a view illustrating the electronic device 300, the cover 400, and the external device 500 according to an embodiment, taken along line A-A of FIG. 4B.

In an embodiment, the groove 460 may be formed in at least a portion of the cover 400. The groove 460 may be formed on some of the surfaces surrounding a region of the placement space 430 that is not covered by the partition wall 420.

In an embodiment, the groove 460 may be formed such that a portion of the cover 400 is recessed relative to another portion.

In an embodiment, the groove 460 may be formed in the support surface 405 and the first cover side surface 411. For example, the groove 460 may extend from the support surface 405 to the first cover hole 440 formed in the first cover side surface 411.

In an embodiment, as the groove 460 is formed, the size of the acoustic duct AD (see FIG. 6B) may be expanded. As the size of the acoustic duct AD (see FIG. 6B) is expanded, a sound generated outside may be more easily delivered to the input device 340 of the electronic device 300.

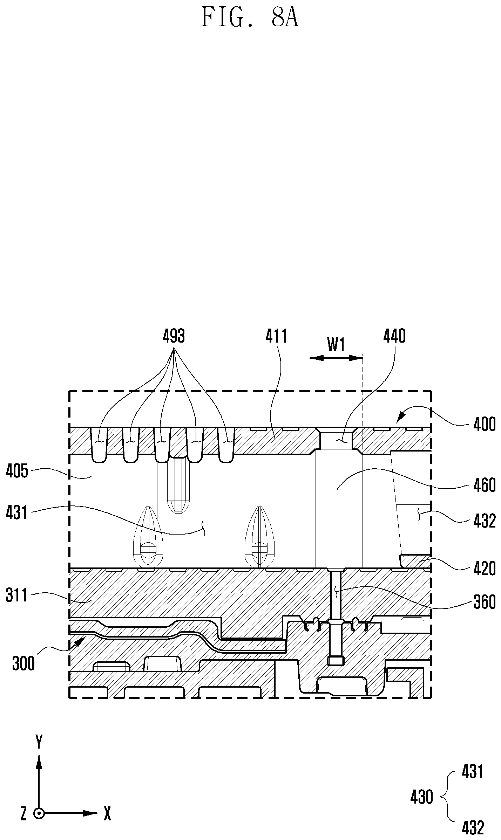

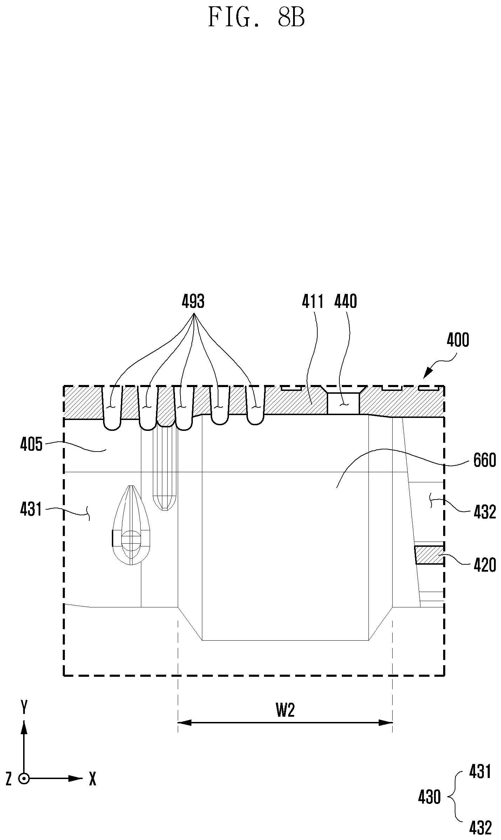

FIGS. 8A and 8B are views illustrating a placement space 430 and a groove 460 according to an embodiment of the disclosure.

FIG. 8A is a view illustrating the placement space 430 and the groove 460 of the cover 400 according to an embodiment. FIG. 8A may be a view illustrating the groove 460 of the cover 400 according to an embodiment, taken along line B-B of FIG. 7.

FIG. 8B is a view illustrating the placement space 430 and a groove 560 of the cover 400 according to an embodiment. FIG. 8B may be a view in which the electronic device 300 (see FIG. 3A) is omitted.

Referring to FIG. 8A, when the cover 400 is mounted on the electronic device 300, the first side surface 311 of the electronic device 300 may face the first cover side surface 411 of the cover 400. When the cover 400 is mounted on the electronic device 300, the first cover hole 440 formed in the first cover side surface 411 may be disposed to be aligned with the first opening 360 formed in the first side surface 311.

Referring to FIG. 8A, at least a portion of the groove 460 of the cover 400 according to an embodiment may extend between the first opening 360 and the first cover hole 440 when viewed in the height direction of the cover 400 (e.g., the Z-axis direction).

Referring to FIG. 8A, the placement space 430 may include a first space 431 and/or a second space 432. The first space 431 may be a region of the placement space 430 that is not covered by the partition wall 420. The second space 432 may be a region of the placement space 430 that is covered by the partition wall 420.

Referring to FIG. 8A, the groove 460 of the cover 400 according to an embodiment may be formed in the first space 431. The groove 460 of the cover 400 may be formed in a shape in which a portion of the support surface 405 surrounding the first space 431 is recessed.

Referring to FIGS. 8A and 8B, the cover 400 may include a dummy hole 493. In an embodiment, the cover 400 may include a plurality of dummy holes 493. In an embodiment, the dummy holes 493 may be holes formed to provide an aesthetic effect to a user of the cover 400.

In an embodiment, the plurality of dummy holes 493 may be formed in the first cover side surface 411 of the cover 400.

In an embodiment, the plurality of dummy holes 493 may be spaced apart from the first cover hole 440. For example, the plurality of dummy holes 493 may each be spaced apart from the first cover hole 440 in the width direction of the cover 400 (e.g., the X-axis direction).

Referring to FIG. 8B, the groove 660 of the cover 400 according to an embodiment may be formed in a shape expanded relative to the groove 460 of the cover 400 of FIG. 8A. For example, the groove 460 of FIG. 8A may have a first width W1, and the groove 660 of FIG. 8B may have a second width W2 greater than the first width W1.

Referring to FIG. 8B, the groove 660 of the cover 400 according to an embodiment may be formed in the first space 431. The groove 660 of the cover 400 may be formed in a shape in which a portion of the support surface 405 surrounding the first space 431 is recessed.

Referring to FIG. 8B, the groove 660 of the cover 400 according to an embodiment may be formed to extend to at least one dummy hole 493. For example, when viewed in the height direction of the cover 400 (e.g., the Z-axis direction), at least a portion of the groove 660 of the cover 400 may extend to a position overlapping the at least one dummy hole 493.

In an embodiment, as the groove 660 is formed, the size of the acoustic duct AD (see FIG. 6B) may be expanded. As the size of the acoustic duct AD (see FIG. 6B) is expanded, a sound generated outside may be more easily delivered to the input device 340 (see FIG. 6B) of the electronic device 300 (see FIG. 6B).

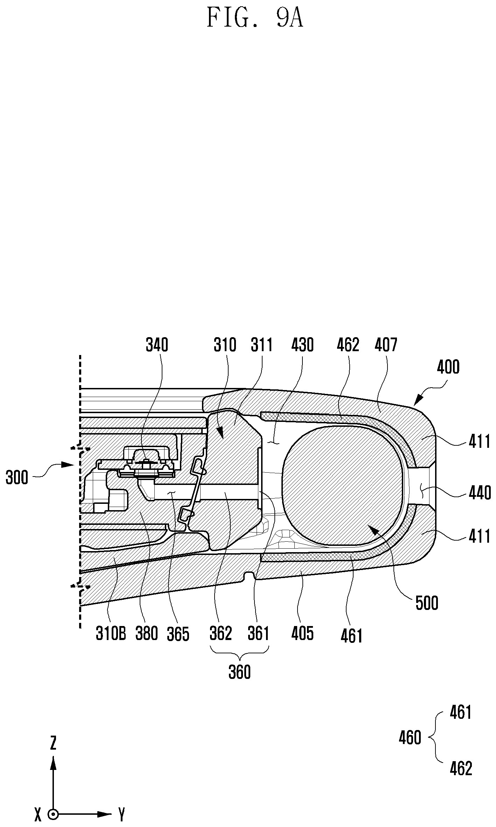

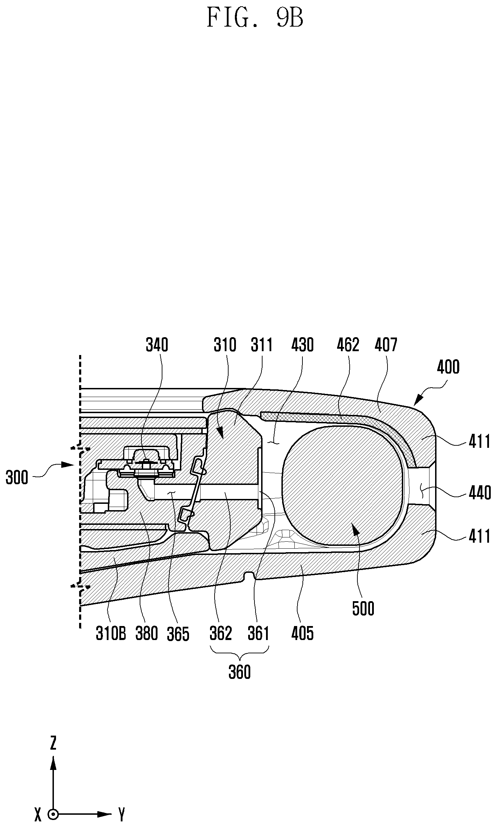

FIGS. 9A and 9B are views illustrating a first groove 461 and a second groove 462 according to an embodiment of the disclosure.

FIGS. 9A and 9B may be views illustrating the electronic device 300, the cover 400, and the external device 500 according to an embodiment, taken along line A-A of FIG. 4B.

In an embodiment, the groove 460 may include the first groove 461 and/or the second groove 462.

Referring to FIG. 9A, the cover 400 according to an embodiment may include the first groove 461 and the second groove 462.

In an embodiment, the first groove 461 may be formed in a first direction (e.g., the negative Z-axis direction) with respect to the placement space 430. The second groove 462 may be formed in a second direction (e.g., the positive Z-axis direction), which is opposite to the first direction, with respect to the placement space 430.

In an embodiment, the first groove 461 and the second groove 462 may be formed in a shape in which a portion of a surface of the cover 400 is recessed relative to another portion.

In an embodiment, the first groove 461 may be formed in the support surface 405 and the first cover side surface 411. For example, the first groove 461 may extend from the support surface 405 to the first cover hole 440 formed in the first cover side surface 411.

In an embodiment, the second groove 462 may be formed in the cover top surface 407 and the first cover side surface 411. For example, the second groove 462 may extend from the cover top surface 407 to the first cover hole 440 formed in the first cover side surface 411.

In an embodiment, as the first groove 461 and the second groove 462 are simultaneously formed, the size of the acoustic duct AD (see FIG. 6B) may be expanded. As the size of the acoustic duct AD (see FIG. 6B) is expanded, a sound generated outside may be more easily delivered to the input device 340 of the electronic device 300.

Referring to FIG. 9B, the cover 400 according to an embodiment may include only the second groove 462. For example, the cover 400 according to an embodiment may not include the first groove 461 formed in the support surface 405 and may include only the second groove 462 formed in the cover top surface 407.

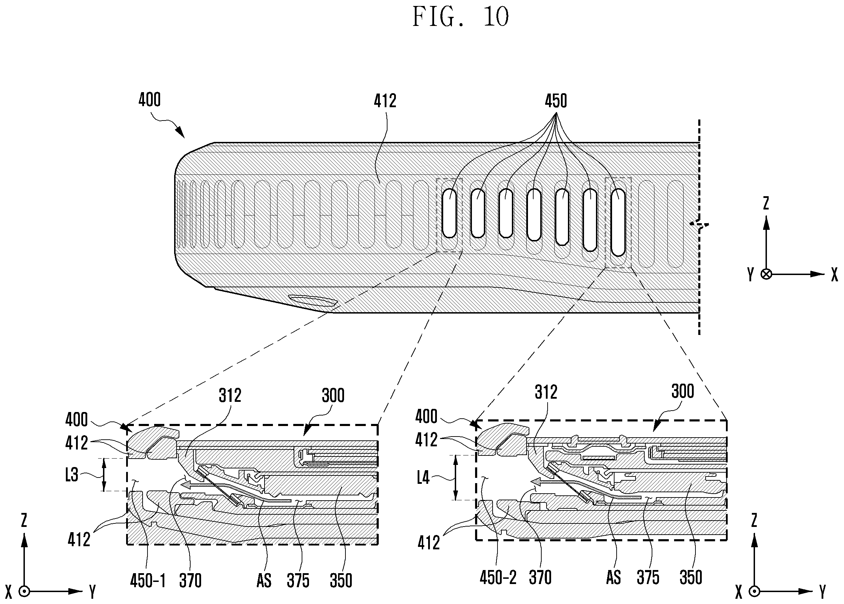

FIG. 10 is a view illustrating a second cover hole 450 according to an embodiment of the disclosure.

In an embodiment, the electronic device 300 may include an acoustic output device 350.

In an embodiment, the acoustic output device 350 may be a device that generates a sound. For example, the acoustic output device 350 may include a speaker that generates a sound.

In an embodiment, the electronic device 300 may include a second opening 370. The second opening 370 may be formed in the second side surface 312 of the housing 310 of the electronic device 300. A sound generated by the acoustic output device 350 may be delivered to the outside of the electronic device 300 through the second opening 370.

In an embodiment, the electronic device 300 may include a second duct 375 extending toward the acoustic output device 350. The second duct 375 may be connected to the second opening 370 and may extend toward the acoustic output device 350.

In an embodiment, a sound generated by the acoustic output device 350 may be delivered to the outside of the electronic device 300 through the second duct 375 and the second opening 370. For example, a sound generated by the acoustic output device 350 may be delivered through the second duct 375 and the second opening 370 along an acoustic delivery path AS.

In an embodiment, the cover 400 may include a second cover hole 450. The second cover hole 450 may be formed in the second cover side surface 412 of the cover 400.

In an embodiment, when the cover 400 is mounted on the electronic device 300, the second opening 370 of the electronic device 300 and the second cover hole 450 of the cover 400 may be positioned to be aligned with each other. For example, when viewed in the length direction of the cover 400 (e.g., the Y-axis direction), the second opening 370 and the second cover hole 450 may be positioned to overlap each other.

In an embodiment, a plurality of second cover holes 450 may be formed. The plurality of second cover holes 450 may be formed to be spaced apart from each other in the width direction of the cover 400 (e.g., the X-axis direction).

In an embodiment, the second cover holes 450 may be disposed to face the second side surface 312 of the housing 310 in which the second opening 370 is formed.

In an embodiment, at least some of the plurality of second cover holes 450 may be formed to have lengths different from those of the remaining second cover holes 450. For example, among the plurality of second cover holes 450, a (2-2)^{th} cover hole 450-2 positioned at one end (e.g., an end in the positive X-axis direction) may be formed longer than a (2-1)^{th} cover hole 450-1 positioned at the other end (e.g., an end in the negative X-axis direction). For example, the (2-1)^{th} cover hole 450-1 may have a third length L3 in the height direction of the cover 400 (e.g., the Z-axis direction), and the (2-2)^{th} cover hole 450-2 may have a fourth length L4 in the height direction of the cover 400 (e.g., the Z-axis direction), the fourth length L4 being greater than the third length L3. In an embodiment, the third length L3 may be about 3.5 to 4.0 mm. The fourth length L4 may be about 5.0 to 5.5 mm.

In an embodiment, lengths by which the plurality of second cover holes 450 extend in the height direction of the cover 400 (e.g., the Z-axis direction) may increase in the width direction of the cover 400 (e.g., the X-axis direction). For example, referring to FIG. 10, the length of the second cover holes 450 may increase as the second cover holes 450 are positioned in the positive X-axis direction.

In an embodiment, when the lengths of the second cover holes 450 are increased, acoustic performance of the electronic device 300 on which the cover 400 is mounted may be improved. For example, a sound vibration phenomenon in sound measured in the electronic device 300 on which the cover 400 having the second cover holes 450 formed therein is mounted may be improved. A sound pressure level in a high-frequency band measured in the electronic device 300 on which the cover 400 having the second cover holes 450 formed therein is mounted may be improved.

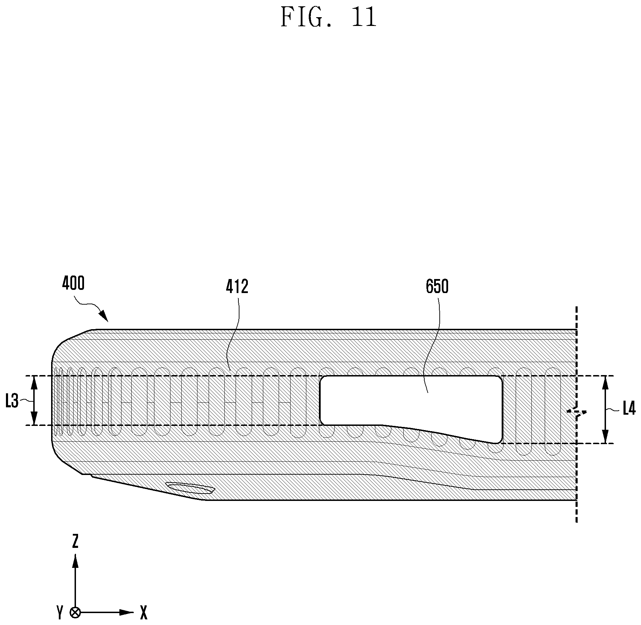

FIG. 11 is a view illustrating a second cover hole 650 according to an embodiment of the disclosure.

In an embodiment, the cover 400 may include a single second cover hole 650. For example, referring to FIG. 11, a single second cover hole 650 may be formed to extend in the second cover side surface 412 of the cover 400.

In an embodiment, the second cover hole 650 may extend in the width direction (e.g., the X-axis direction) and the height direction (e.g., the Z-axis direction) of the cover 400.

In an embodiment, the second cover hole 650 may be formed such that a length at one end and a length at the other end differ from each other. For example, referring to FIG. 11, a length by which one end (e.g., the end in the positive X-axis direction) of the second cover hole 650 extends in the height direction of the cover 400 (e.g., the Z-axis direction) may be greater than a length by which the other end (e.g., the end in the negative X-axis direction) of the second cover hole 650 extends in the height direction of the cover 400 (e.g., the Z-axis direction). For example, the one end of the second cover hole 650 may have a fourth length L4, and the other end of the second cover hole 650 may have a third length L3 smaller than the fourth length L4.

In an embodiment, when the second cover hole 650 is formed such that the length at one end and the length at the other end differ from each other, the size of the second cover hole 650 may be relatively expanded. For example, the size of the second cover hole 650 may be relatively expanded as compared with a case in which lengths of both ends are formed as the third length L3.

In an embodiment, when the size of the second cover hole 650 is expanded, acoustic performance of the electronic device 300 on which the cover 400 is mounted may be improved. For example, a sound vibration phenomenon in sound measured in the electronic device 300 on which the cover 400 having the second cover hole 650 formed therein is mounted may be improved. A sound pressure level in a high-frequency band measured in the electronic device 300 on which the cover 400 having the second cover hole 650 formed therein is mounted may be improved.

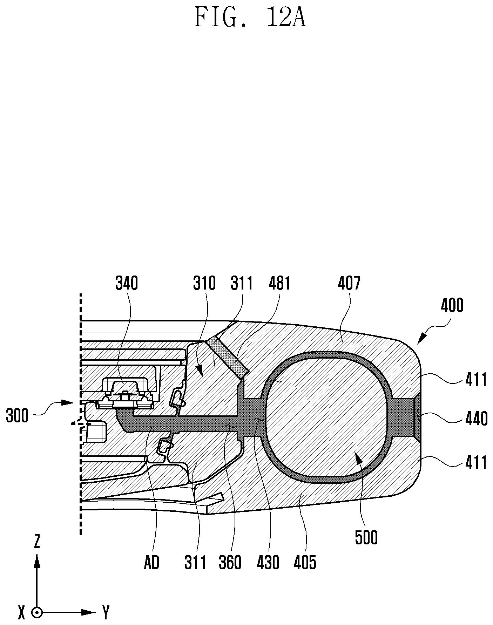

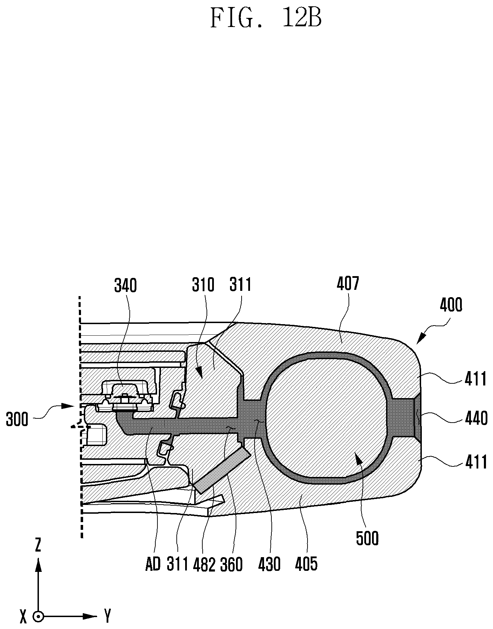

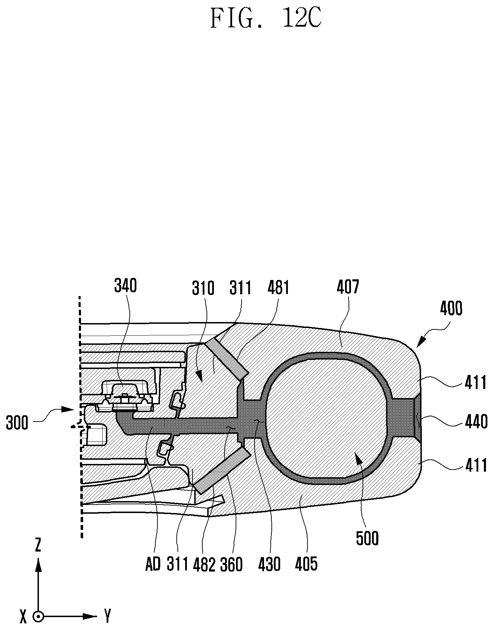

FIGS. 12A, 12B, and 12C are views illustrating passages 481 and 482 according to an embodiment of the disclosure.

In an embodiment, the electronic device 300 and the cover 400 may form the passages 481 and 482. For example, the passages 481 and 482 may be formed as a portion of the cover 400 facing the first side surface 311 of the housing 310 is spaced apart from the first side surface 311 of the housing 310.

In an embodiment, the passages 481 and 482 may be connected to the placement space 430 and may be exposed to the outside of the electronic device 300 on which the cover 400 is mounted.

In an embodiment, the passages 481 and 482 may include a first passage 481 and/or a second passage 482.

Referring to FIG. 12A, the cover 400 according to an embodiment may form the first passage 481. In an embodiment, the cover top surface 407 of the cover 400 may be formed to be spaced apart from the first side surface 311 of the housing 310 of the electronic device 300 by a predetermined length. For example, a portion of the cover top surface 407 may be removed so that the cover top surface 407 may be spaced apart from the first side surface 311 by a predetermined length. The first passage 481 may be formed as the cover top surface 407 is spaced apart from the first side surface 311 by a predetermined length. The first passage 481 may be connected to the placement space 430 and may be exposed to the outside of the electronic device 300 on which the cover 400 is mounted.

Referring to FIG. 12B, the cover 400 according to an embodiment may form the second passage 482. In an embodiment, the support surface 405 of the cover 400 may be formed to be spaced apart from the first side surface 311 of the housing 310 of the electronic device 300 by a predetermined length. For example, a portion of the support surface 405 may be removed so that the support surface 405 may be spaced apart from the first side surface 311 by a predetermined length. The second passage 482 may be formed as the support surface 405 is spaced apart from the first side surface 311 by a predetermined length. The second passage 482 may be connected to the placement space 430 and may be exposed to the outside of the electronic device 300 on which the cover 400 is mounted.

Referring to FIG. 12C, the cover 400 according to an embodiment may simultaneously form the first passage 481 and the second passage 482. The cover top surface 407 and the support surface 405 may be partially removed so that the cover top surface 407 and the support surface 405 are spaced apart from the first side surface 311 by a predetermined length, and the first passage 481 and the second passage 482 may be formed. The first passage 481 and the second passage 482 may be connected to the placement space 430 and may be exposed to the outside of the electronic device 300 on which the cover 400 is mounted.

In an embodiment, the passages 481 and 482 may be formed in a hole shape in a portion of the cover 400. For example, the passages 481 and 482 may be formed in a hole shape passing through the support surface 405 and/or the cover top surface 407.

In an embodiment, the passages 481 and 482 may provide an effect of expanding the acoustic duct AD through which a sound is delivered. For example, since the passages 481 and 482 are connected to the placement space 430 in which the acoustic duct AD is formed, the passages 481 and 482 may provide an effect of expanding the acoustic duct AD. As the acoustic duct AD is expanded, a sound generated outside may be more easily delivered to the input device 340 of the electronic device 300.

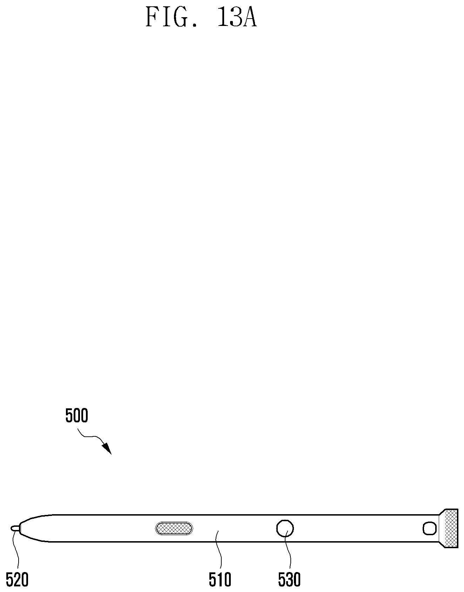

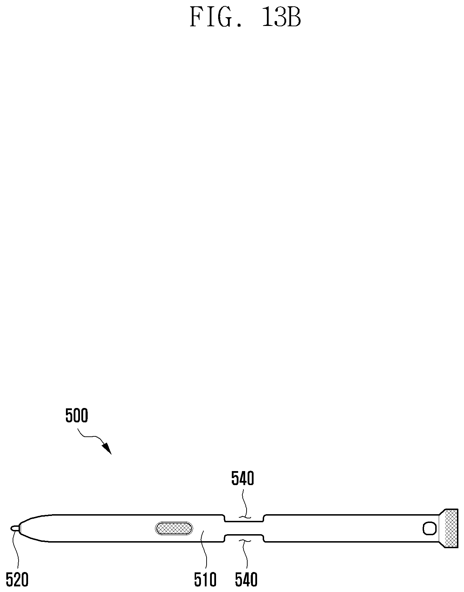

FIGS. 13A and 13B are views illustrating an external device 500 according to an embodiment of the disclosure.

FIG. 13A is a view illustrating an external device 500 including a passing hole 530 according to an embodiment. FIG. 13B is a view illustrating an external device 500 including a recessed region 540 according to an embodiment.

The external device 500 according to an embodiment of the disclosure may include a body 510 and/or a pen tip 520.

In an embodiment, the body 510 may form an exterior of the external device 500. At least some of the components of the external device 500 may be disposed in the body 510. The body 510 may extend relatively long in one direction.

In an embodiment, the pen tip 520 may be formed at an end of the body 510. The pen tip 520 may be brought into contact with the display 320 of the electronic device 300 and may serve to deliver an input signal to the electronic device 300.

Referring to FIG. 13A, the external device 500 according to an embodiment may include the passing hole 530. The passing hole 530 may be formed to pass through a portion of the body 510.

In an embodiment, the passing hole 530 may be formed at a position corresponding to the first opening 360 (see FIG. 6A) of the electronic device 300 (see FIG. 6A) and the first cover hole 440 (see FIG. 6A) of the cover 400 (see FIG. 6A). For example, when the cover 400 (see FIG. 6A) is mounted on the electronic device 300 (see FIG. 6A) and the external device 500 is placed in the cover 400 (see FIG. 6A), the passing hole 530, the first opening 360 (see FIG. 6A), and the first cover hole 440 (see FIG. 6A) may be disposed to be aligned with each other.

In an embodiment, as the passing hole 530, the first opening 360 (see FIG. 6A), and the first cover hole 440 (see FIG. 6A) are aligned, the acoustic duct AD (see FIG. 6B) through which a sound is delivered may be further expanded. As the acoustic duct AD (see FIG. 6B) is expanded, a sound may be more easily delivered to the input device 340 (see FIG. 6A) of the electronic device 300 (see FIG. 6A).

Referring to FIG. 13B, the external device 500 according to an embodiment may include a recessed region 540. The recessed region 540 may be formed in a shape in which a region of the body 510 is recessed relative to another region.

In an embodiment, the recessed region 540 may be formed at a position corresponding to the first opening 360 (see FIG. 6A) of the electronic device 300 (see FIG. 6A) and the first cover hole 440 (see FIG. 6A) of the cover 400 (see FIG. 6A). For example, when the cover 400 (see FIG. 6A) is mounted on the electronic device 300 (see FIG. 6A) and the external device 500 is placed in the cover 400 (see FIG. 6A), the recessed region 540, the first opening 360 (see FIG. 6A), and the first cover hole 440 (see FIG. 6A) may be disposed to be aligned with each other.

In an embodiment, as the recessed region 540, the first opening 360 (see FIG. 6A), and the first cover hole 440 (see FIG. 6A) are aligned, the acoustic duct AD (see FIG. 6B) through which a sound is delivered may be further expanded. As the acoustic duct AD (see FIG. 6B) is expanded, a sound may be more easily delivered to the input device 340 (see FIG. 6A) of the electronic device 300 (see FIG. 6A).

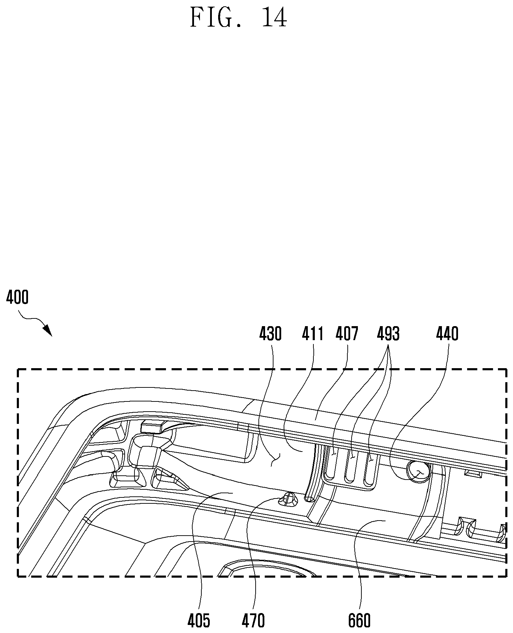

FIG. 14 is a view illustrating a protrusion 470 according to an embodiment of the disclosure.

In an embodiment, the cover 400 may include the protrusion 470. Referring to FIG. 14, the protrusion 470 may be formed in the placement space 430 of the cover 400.

In an embodiment, the protrusion 470 may be formed such that a portion of a surface surrounding the placement space 430 protrudes. For example, the protrusion 470 may be formed as a portion of the support surface 405 surrounding the placement space 430 protrudes relative to another portion.

In an embodiment, the protrusion 470 may serve to fix the position of the external device 500 (see FIG. 5) placed in the cover 400. For example, when the external device 500 (see FIG. 5) is placed in the cover 400, the protrusion 470 may be inserted into at least a portion of the external device 500 (see FIG. 5), so that the position of the external device 500 (see FIG. 5) may be fixed. In an embodiment, the external device 500 (see FIG. 5) may include a recessed groove (not illustrated) formed in a shape corresponding to the protrusion 470.

Although FIG. 14 illustrates that the protrusion 470 is formed by a portion of the support surface 405 protruding relative to another portion, this is merely exemplary, and a position where the protrusion 470 is formed may not be limited thereto. For example, the protrusion 470 may be formed as the cover top surface 407 and/or the first cover side surface 411 partially protrudes.

Referring to FIG. 14, a groove 660 may be formed in a portion of the support surface 405. The groove 660 may be formed as a portion of the support surface 405 is recessed. In an embodiment, the groove 660 may be formed to overlap the first cover hole 440 and the dummy hole 493. As the groove 660 is formed in a portion of the support surface 405, the acoustic duct AD (see FIG. 6B) may be expanded.

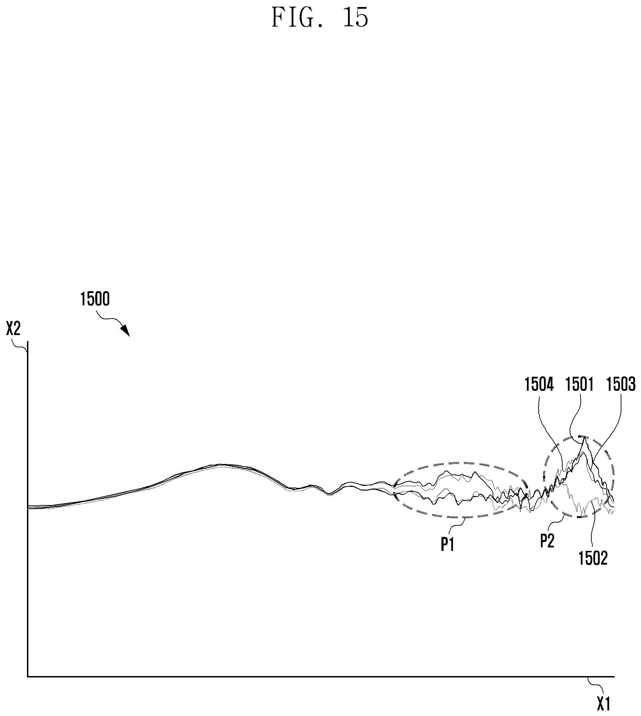

FIG. 15 is a first graph 1500 illustrating a sound pressure level of a sound measured at the input device 340 according to an embodiment of the disclosure.

The horizontal axis X1 of the first graph 1500 illustrated in FIG. 15 may represent a frequency (e.g., hertz (Hz)) of a sound delivered to the input device 340.

The vertical axis X2 of the first graph 1500 illustrated in FIG. 15 may be an indicator representing acoustic performance of the input device 340. For example, the vertical axis X2 of the first graph 1500 may indicate a sound pressure level (SPL) (e.g., decibel (dB)) of a sound measured at the input device 340.

The first graph 1500 of FIG. 15 may include a first measurement line 1501, a second measurement line 1502, a third measurement line 1503, and a fourth measurement line 1504.

In an embodiment, the first measurement line 1501 may indicate a sound pressure level received by the input device 340 when the cover 400 is not mounted on the electronic device 300.

In an embodiment, the second measurement line 1502 may indicate a sound pressure level measured at the input device 340 when a conventional cover other than the cover 400 according to an embodiment of the disclosure is mounted on the electronic device 300.

In an embodiment, the third measurement line 1503 may indicate a sound pressure level measured at the input device 340 when the cover 400 in which the groove 460 according to an embodiment of the disclosure is formed is mounted on the electronic device 300.

In an embodiment, the fourth measurement line 1504 may indicate a sound pressure level measured at the input device 340 when the cover 400 in which the groove 660 according to an embodiment of the disclosure is formed is mounted on the electronic device 300.

Referring to the first graph 1500 of FIG. 15, when the cover 400 according to an embodiment of the disclosure is mounted on the electronic device 300, acoustic performance of the electronic device 300 may be improved as compared with when a conventional cover is mounted on the electronic device 300. For example, referring to a first observation region P1, sound pressure level values of the third measurement line 1503 and the fourth measurement line 1504, which correspond to a case in which the cover 400 according to an embodiment of the disclosure is mounted on the electronic device 300, may be greater than a sound pressure level value of the second measurement line 1502, which corresponds to a case in which a conventional cover is mounted on the electronic device 300. The frequency range of the first observation region P1 may be 1 kHz to 3 kHz. In the first observation region P1, a sound pressure level value of the fourth measurement line 1504 may be about 5 dB greater than a sound pressure level value of the second measurement line 1502. Referring to a second observation region P2, sound pressure level values of the third measurement line 1503 and the fourth measurement line 1504, which correspond to a case in which the cover 400 according to an embodiment of the disclosure is mounted on the electronic device 300, may be smaller than a sound pressure level value of the first measurement line 1501, which corresponds to a case in which the cover 400 is not mounted on the electronic device 300, but may be greater than a sound pressure level value of the second measurement line 1502, which corresponds to a case in which a conventional cover is mounted on the electronic device 300. The frequency range of the second observation region P2 may be 6 kHz to 9 kHz. In the second observation region P2, a sound pressure level value of the fourth measurement line 1504 may be about 10 dB greater than a sound pressure level value of the second measurement line 1502.

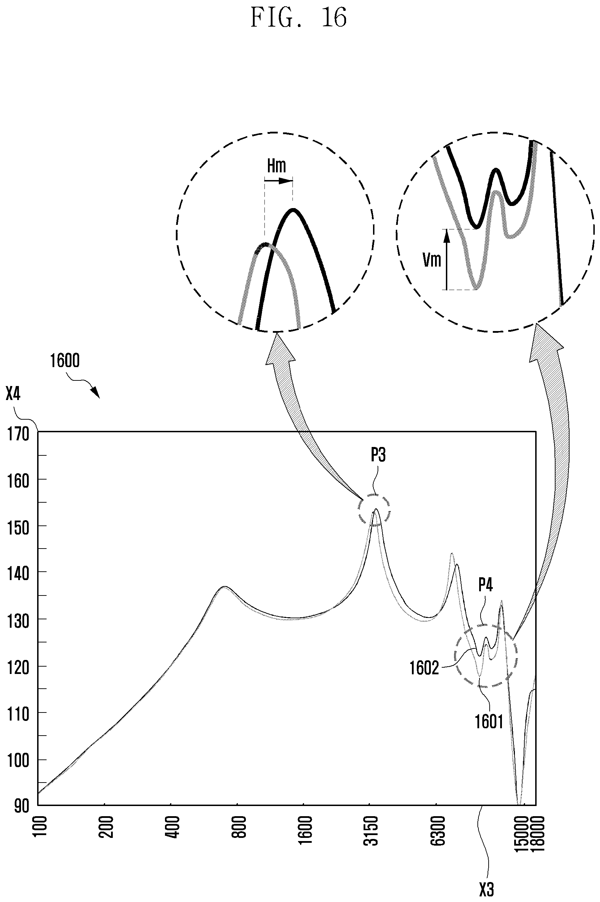

FIG. 16 is a second graph 1600 illustrating a sound pressure level of a sound generated by the acoustic output device 350 according to an embodiment of the disclosure.

The horizontal axis X3 of the second graph 1600 illustrated in FIG. 16 may represent a frequency (e.g., hertz (Hz)) of a sound generated by the acoustic output device 350.

The vertical axis X4 of the second graph 1600 illustrated in FIG. 16 may be an indicator representing acoustic performance of the acoustic output device 350. For example, the vertical axis X4 of the second graph 1600 may indicate a sound pressure level (SPL) (e.g., decibel (dB)) of a sound generated by the acoustic output device 350.

The second graph 1600 of FIG. 16 may include a fifth measurement line 1601 and a sixth measurement line 1602.

In an embodiment, the fifth measurement line 1601 may indicate a value obtained by measuring, outside the electronic device 300, the sound pressure level of a sound generated by the acoustic output device 350 when a conventional cover other than the cover 400 according to an embodiment of the disclosure is mounted on the electronic device 300.

In an embodiment, the sixth measurement line 1602 may indicate a value obtained by measuring, outside the electronic device 300, the sound pressure level of a sound generated by the acoustic output device 350 when the cover 400 in which the second cover hole 450 according to an embodiment of the disclosure is formed is mounted on the electronic device 300.

Referring to the second graph 1600 of FIG. 16, when the cover 400 in which the second cover hole 450 according to an embodiment of the disclosure is formed is mounted on the electronic device 300, acoustic performance of the electronic device 300 in a high-frequency band may be improved compared with when a conventional cover is mounted on the electronic device 300.

Referring to the second graph 1600 of FIG. 16, the sixth measurement line 1602, which corresponds to a case in which the cover 400 in which the second cover hole 450 according to an embodiment of the disclosure is formed is mounted on the electronic device 300, may be horizontally shifted (Hm) relative to the fifth measurement line 1601, which corresponds to a case in which a conventional cover is mounted on the electronic device 300. For example, referring to a third observation region P3, the sixth measurement line 1602 may be horizontally shifted (Hm) by about 170 Hz relative to the fifth measurement line 1601. The fact that the sixth measurement line 1602 is horizontally shifted (Hm) relative to the fifth measurement line 1601 may indicate that, in a high-frequency band, a sound pressure level value of the sixth measurement line 1602 is greater than a sound pressure level value of the fifth measurement line 1601.

Referring to the second graph 1600 of FIG. 16, as the sixth measurement line 1602 is horizontally shifted (Hm) relative to the fifth measurement line 1601, the sixth measurement line 1602 may be vertically shifted (Vm) relative to the fifth measurement line 1601 in a high-frequency band (e.g., 9,000 to 10,000 Hz). For example, referring to a fourth observation region P4, in a high-frequency band (e.g., 9,000 to 10,000 Hz), the sixth measurement line 1602 may be vertically shifted (Vm) relative to the fifth measurement line 1601, so that a sound pressure level value of the sixth measurement line 1602 may be greater than a sound pressure level value of the fifth measurement line 1601.

When a cover is mounted on an electronic device, a portion of the cover may block an acoustic duct of the electronic device, so that acoustic performance of the electronic device may be degraded.

When an external device (e.g., a digital pen) is placed in the cover while the cover is mounted on the electronic device, the acoustic duct may be reduced by the external device (e.g., the digital pen), and the acoustic performance of the electronic device may be degraded.

The cover may include a cover hole (e.g., a second cover hole) through which a sound generated by an acoustic output device (e.g., a speaker) may pass, but the acoustic duct may become longer by the thickness of the cover, so that the acoustic performance of the electronic device may be degraded.

An electronic device 300 according to an embodiment of the disclosure may include a cover 400 mounted thereon.

In an embodiment, the electronic device 300 may include an input device 340 configured to receive a sound and a housing 310 including a first opening 360 through which the sound delivered to the input device 340 passes.

In an embodiment, the cover 400 may include a first cover hole 440, a placement space 430, and a partition wall 420.

In an embodiment, the first cover hole 440 may be formed at a position overlapping the first opening 360.

In an embodiment, the placement space 430 may be formed between a first side surface 311 of the housing 310 in which the first opening 360 is formed and a first cover side surface 411 of the cover 400 in which the first cover hole 440 is formed, and an external device 500 may be placed in the placement space 430.

In an embodiment, the partition wall 420 may face the first side surface 311 and may cover a portion of the placement space 430.

In an embodiment, a region of the placement space 430 that is not covered by the partition wall 420 may extend from the first opening 360 to the first cover hole 440.

In the electronic device 300 on which the cover 400 according to an embodiment of the disclosure is mounted, a portion of the partition wall 420 formed in the cover 400 may be removed so that an acoustic duct AD corresponding to the first opening 360 of the electronic device 300 may be expanded.

In an embodiment, the electronic device 300 may include an acoustic output device 350.

In an embodiment, the electronic device 300 may include a second opening 370 through which a sound generated by the acoustic output device 350 passes.

In an embodiment, the cover 400 may include a plurality of second cover holes 450 overlapping the second opening 370 and formed to be spaced apart from each other on a second cover side surface 412 of the cover 400 facing a second side surface 312 of the housing in which the second opening 370 is formed.

In an embodiment, the plurality of second cover holes 450 may be formed to have different lengths from each other.

In an embodiment, lengths by which the plurality of second cover holes 450 extend in a height direction of the cover 400 may increase or decrease along the length direction of the cover 400.

In the electronic device 300 on which the cover 400 according to an embodiment of the disclosure is mounted, acoustic performance may be improved by configuring at least some of the plurality of second cover holes 450 corresponding to the second opening 370 of the electronic device 300 to have extended lengths.

In an embodiment, the cover 400 may include grooves 460 and 660 formed on some of the surfaces surrounding a region of the placement space 430 that is not covered by the partition wall 420.

In an embodiment, at least a portion of the groove 460 may extend between the first opening 360 and the first cover hole 440 when viewed in the height direction of the cover 400.

In an embodiment, the cover 400 may include a dummy hole 493 spaced apart from the first cover hole 440.

In an embodiment, at least a portion of the groove 660 may extend to the dummy hole 493 when viewed in the height direction of the cover 400.

In an embodiment, the groove 460 may include a first groove 461 formed in a first direction with respect to the placement space 430 and a second groove 462 formed in a second direction opposite to the first direction with respect to the placement space.

In the electronic device 300 on which the cover 400 according to an embodiment of the disclosure is mounted, a portion of the placement space 430 in which the external device 500 is to be placed in the cover 400 may be formed in a recessed shape, so that an acoustic duct AD corresponding to the first opening 360 of the electronic device 300 may be expanded.

In an embodiment, a portion of the cover 400 facing the first side surface 311 of the housing 310 may be spaced apart from the first side surface 311 of the housing 310 to form passages 481 and 482. The passages 481 and 482 may extend from the placement space 430 and may be exposed to an exterior of the electronic device 300 on which the cover 400 is mounted.

The electronic device 300 on which the cover 400 according to an embodiment of the disclosure is mounted may improve acoustic performance of the electronic device 300 by forming passages 681 and 682 extending from the acoustic duct AD.

In an embodiment, the cover 400 may include a second cover hole 650 overlapping the second opening 370 and formed on a second cover side surface 412 of the cover 400 facing the second side surface 312 of the housing 310 in which the second opening 370 is formed.

In an embodiment, the second cover hole 650 may be formed such that a length at one end and a length at the other end differ from each other.

In an embodiment, the cover 400 may further include a protrusion 470 formed on at least a portion of a surface surrounding a region of the placement space 430 that is not covered by the partition wall 420 and configured to fix the external device 500.

The cover 400 according to an embodiment of the disclosure may include the protrusion 470 configured to fix the external device 500 so as to facilitate fixing of the external device 500 to the cover 400.

In an embodiment, the external device 500 may include a passing hole 530.

In an embodiment, when the external device 500 is disposed in the cover 400, the passing hole 530 may be disposed to be aligned with the first opening 360 and the first cover hole 440.

The external device 500 according to an embodiment of the disclosure may include a passing hole 530 disposed to be aligned with the first opening 360 and the first cover hole 440, so that an acoustic duct AD of the electronic device 300 may be expanded.

In an embodiment, the first opening 360 may include a first portion 361 located on the first side surface 311 of the housing 310 and a second portion 362 having a width smaller than that of the first portion 361 and extending in a direction toward the input device 340.

In an embodiment, the partition wall 420 of the cover 400 may be formed so as not to overlap the first portion 361.

In an embodiment, the second side surface 312 of the housing 310 may be a side surface located in a direction opposite to the first side surface 311 of the housing 310.

A cover 400 mountable on an electronic device 300 according to an embodiment of the disclosure may include a first cover hole 440, a placement space 430, and a partition wall 420.

In an embodiment, the first cover hole 440 may be formed at a position capable of overlapping the first opening 360 of the electronic device 300 through which a sound delivered to the electronic device 300 passes.

In an embodiment, the placement space 430 may be a space in which the external device 500 is disposed.

In an embodiment, the partition wall 420 may face the first side surface 311 of the electronic device 300 and may cover a portion of the placement space 430.

In an embodiment, when the cover 400 is mounted on the electronic device 300, a region of the placement space 430 that is not covered by the partition wall 420 may extend from the first opening 360 to the first cover hole 440.

In the cover 400 according to an embodiment of the disclosure, an acoustic duct AD corresponding to the first opening 360 of the electronic device 300 may be expanded by removing a portion of the partition wall 420 formed in the cover 400.

In an embodiment, a plurality of second cover holes 450 may overlap the second opening 370 of the electronic device 300 through which a sound passes, and may be formed to be spaced apart from each other on the second cover side surface 412 facing the second side surface 312 of the electronic device 300 in which the second opening 370 is formed. The plurality of second cover holes 450 may be formed to have different lengths from each other.

In an embodiment, when the external device 500 is disposed in the cover 400, the passing hole 530 may be disposed to be aligned with the first cover hole 440.

The technical subjects pursued in the disclosure may not be limited to the above-mentioned technical subjects, and other technical subjects which are not mentioned herein may be clearly understood from the following description by those skilled in the art to which the disclosure pertains.

Advantageous effects obtainable from the disclosure are not limited to the effects mentioned above, and other effects not mentioned herein will be clearly understood by those skilled in the art to which the disclosure belongs.

An electronic device according to an embodiment of the disclosure may be one of various types of electronic devices. The electronic devices may include, for example, a portable communication device (e.g., a smartphone), a computer device, a portable multimedia device, a portable medical device, a camera, a wearable device, or a home appliance. The electronic device according to an embodiment of the disclosure is not limited to those described above.

It should be appreciated that an embodiment of the disclosure and the terms used therein are not intended to limit the technological features set forth herein to particular embodiments and the disclosure includes various changes, equivalents, or alternatives for a corresponding embodiment. In relation to the description of the drawings, similar reference numerals may be used for similar or related components. The singular form of a noun corresponding to an item may include one item or a plurality of items unless the context clearly indicates otherwise. As used herein, each of such phrases as "A or B," "at least one of A and B," "at least one of A or B," "A, B, or C," at least one of A, B, and C,"and "at least one of A, B, or C," may include all possible combinations of the items enumerated together in a corresponding one of the phrases. Such terms as "a first", "a second", "the first", and "the second" may be used to simply distinguish a corresponding element from another, and does not limit the elements in other aspect (e.g., importance or order). When a certain (e.g., a first) component is mentioned as being "coupled" or "connected" to another (e.g., a second) component, with or without a term "functionally" or "communicatively," it means that the certain component may be connected to the other component directly (e.g., wiredly), wirelessly, or via a third component.

As used in an embodiment of the disclosure, the term "module" may include a unit implemented in hardware, software, or firmware, and may be interchangeably used with other terms, for example, "logic," "logic block," "component," or "circuit". The module may be an integrally configured component or a minimum unit or a portion of the component, which performs one or more functions. For example, according to an embodiment, the module may be implemented in the form of an application-specific integrated circuit (ASIC).

An embodiment of the disclosure may be implemented as software (e.g., the program 101) including one or more instructions that are stored in a storage medium (e.g., the internal memory 136 or external memory 138) that is readable by a machine (e.g., the electronic device 140). For example, a processor (e.g., the processor 120) of a device (e.g., the electronic device 101) may invoke and execute at least one of the stored one or more instructions from the storage medium. This enables the device to be operated to perform at least one function in response to the at least one invoked instruction. The one or more instructions may include codes generated by a compiler or code capable of being executed by an interpreter. The machine-readable storage medium may be provided in the form of a non-transitory storage medium. Here, the term "non-transitory" merely means that the storage medium is a tangible device and does not contain a signal (e.g., electromagnetic waves), and this term is not intended to distinguish a case where data is permanently stored on the storage medium and a case where data is temporarily stored.

According to an embodiment, the method according to an embodiment of the disclosure may be included and provided in a computer program product. The computer program product may be traded as a product between a seller and a purchaser. The computer program product may be distributed in the form of a machine-readable storage medium (e.g., a compact disc read-only memory (CD-ROM)), or may be directly distributed through an application store (e.g., Play Store^{™}) or directly between two user devices (e.g., smartphones), or may be distributed online (e.g., downloaded or uploaded). If distributed online, at least part of the computer program product may be temporarily stored or produced in a machine-readable storage medium such as a manufacturer's server, a server of an application store, or the memory of a relay server.

According to an embodiment, each component (e.g., a module or a program) of the above-described components may include a single entity or multiple entities, and some of the multiple entities may be separately disposed in different components. According to an embodiment, one or more of the above-described components may be omitted, or one or more other components may be added. Alternatively, or additionally, multiple components (e.g., modules or programs) may be integrated into a single component. In such a case, the integrated element may perform one or more functions of each of the plurality of elements in the same or similar manner as they are performed by a corresponding one of the plurality of elements before the integration.

According to an embodiment, operations performed by the module, the program, or another component may be carried out sequentially, in parallel, repeatedly, or heuristically, or one or more of the operations may be executed in a different order or omitted, or one or more other operations may be added.

## Claims

1. An electronic device with a cover, comprising:
an input device that receives sound; and
a housing comprising a first opening through which sound received by the input device passes,
wherein the cover comprises:
a first cover hole formed at a position overlapping with the first opening;
a placement space where an external device can be placed, and formed between a first side surface of the housing where the first opening is formed and a first cover side surface of the cover where the first cover hole is formed; and
a partition wall facing the first side surface and covering a portion of the placement space,
wherein a portion of the placement space not covered by the partition wall extends from the first opening to the first cover hole.

2. The electronic device of claim 1, wherein the electronic device further comprises an acoustic output device and a second opening through which sound generated by the acoustic output device passes, and
wherein the cover further comprises a plurality of second cover holes which overlap the second opening and are formed to be spaced apart from each other on a second cover side surface of the cover, the second cover side surface facing a second side surface of the housing where the second opening is formed.

3. The electronic device of claim 2, wherein the plurality of second cover holes are formed to have different lengths.

4. The electronic device of claim 2, wherein a length that the plurality of second cover holes extend in the height direction of the cover increases or decreases in the length direction of the cover.

5. The electronic device of claim 1, wherein the cover further comprises a groove formed on a portion of the surface surrounding the portion of the placement space not covered by the partition wall.

6. The electronic device of claim 5, wherein at least a portion of the groove extends between the first opening and the first cover hole when viewed in the height direction of the cover.

7. The electronic device of claim 5, wherein the cover further comprises a dummy hole spaced apart from the first cover hole, and
wherein at least a portion of the groove extends to the dummy hole when viewed in the height direction of the cover.

8. The electronic device of claim 5, wherein the groove comprises:
a first groove formed in a first direction based on the placement space, and
a second groove formed in a second direction opposite to the first direction based on the placement space.

9. The electronic device of claim 1, wherein a portion of the cover facing the first side surface is spaced apart from the first side surface to form a passage, and
wherein the passage continues from the placement space and is exposed to the outside of the electronic device with the cover.

10. The electronic device of claim 1, wherein the electronic device further comprises a acoustic output device and a second opening through which sound generated by the acoustic output device passes,
wherein the cover further comprises one second cover hole which overlaps the second opening and is formed on a second cover side surface of the cover, the second cover side surface facing a second side surface of the housing where the second opening is formed.

11. The electronic device of claim 10, wherein the one second cover hole is formed such that lengths of one end and the other end are different.

12. The electronic device of claim 1, wherein the cover comprises a protrusion formed on a portion of the surface surrounding the portion of the placement space not covered by the partition wall.

13. The electronic device of claim 1, wherein the external device comprises a passing hole, and
wherein the passing hole is arranged to be aligned with the first opening and the first cover hole when the external device is disposed on the cover.

14. The electronic device of claim 1, wherein the first opening comprises:
a first part located on the first side surface; and
a second part having a width less than that of the first part and extending in a direction toward the input device,
wherein the partition wall is formed so as not to overlap the first part.

15. The electronic device of claim 2, wherein the second side surface is a side located in the opposite direction to the first side surface.
